# EUROPEAN PATENT APPLICATION

(11) **EP 2 323 147 A2**
(43) Date of publication of application: **18.05.2011**
(21) Application number: 10189956.5
(22) Date of filing: 04.11.2010
(51) Int. Cl.: H01G 9/20

(54) **Dye-sensitized solar cell electrode and dye-sensitized solar cell**

(30) Priority: 12.11.2009 JP 2009259131
(71) Applicant: Nitto Denko Corporation, Ibaraki-shi Osaka 567-8680 (JP)
(72) Inventor: Hanazono, Hiroyuki, Osaka 567-8680 (JP); Inoue, Shinichi, Osaka 567-8680 (JP); Shiihara, Kumie, Osaka 567-8680 (JP)
(74) Representative: HOFFMANN EITLE

(57) **Abstract**

A dye-sensitized solar cell electrode includes a substrate; a conductive layer formed on one side surface of the substrate and is surrounded by a sealing layer for sealing in an electrolyte; a current collecting layer formed on the other side surface of the substrate; and a conductive portion that allows electrical conduction between the conductive layer and the current collecting layer in the thickness direction of the substrate.

## Description

### BACKGROUND OF THE INVENTION

### Field of the Invention

The present invention relates to a dye-sensitized solar cell electrode and a dye-sensitized solar cell. To be specific, the present invention relates to a dye-sensitized solar cell electrode suitably used for a working electrode and/or a counter electrode of a dye-sensitized solar cell; and to a dye-sensitized solar cell in which such an electrode is used.

### Description of the Related Art

In recent years, a dye-sensitized solar cell in which a dye-sensitized semiconductor is used has been proposed as a new solar cell that may replace silicon-based solar cells in view of mass production and cost reduction.

A dye-sensitized solar cell usually has a working electrode (anode) having a photosensitizing function, an opposing electrode (counter electrode, cathode) that is disposed to face the working electrode with a space therebetween, a sealing member disposed between those two electrodes, and a liquid electrolyte that is sealed in by the sealing member. In dye-sensitized solar cells, electrons generated in the working electrode based on irradiation by sunlight migrate to the counter electrode via wirings, and the electrons are released and received in the liquid electrolyte between the two electrodes.

In such dye-sensitized solar cells, the working electrode is composed of a transparent substrate (anode-side substrate), a transparent conductive layer that is laminated onto the surface of the transparent substrate, and a semiconductor electrode layer that is laminated onto the surface of the transparent conductive layer and retains dyes; and the opposing electrode is composed of a film exterior material (cathode-side substrate), a base layer that is laminated onto the surface of the film exterior material, and a catalyst layer laminated onto the surface of the base layer. Furthermore, in such a dye-sensitized solar cell, the sealing member is provided as a frame when viewed from the top so as to surround the semiconductor electrode layer, thereby sealing in the liquid electrolyte.

Furthermore, it has been proposed that in dye-sensitized solar cells, current collecting wirings are disposed on the surface of the transparent substrate such that one end of the current collecting wirings is connected to the transparent conductive layer; the other end thereof is provided so as to serve as a portion for taking out electricity; and the middle portion thereof penetrates and traverses the sealing layer (for example, see Japanese Unexamined Patent Publication No. 2007-280906).

### SUMMARY OF THE INVENTION

However, because the current collecting wirings penetrate the sealing member in the dye-sensitized solar cell described in Japanese Unexamined Patent Publication No. 2007-280906, sealing performance of the sealing member at the penetration portion is reduced. Thus, the liquid electrolyte easily leaks out from the penetration portion, and as a result, there are disadvantages in that power generation efficiency of the dye-sensitized solar cell is decreased, and moreover, the surroundings of the dye-sensitized solar cell are contaminated.

An object of the present invention is to provide a dye-sensitized solar cell electrode and a dye-sensitized solar cell in which a reduction in power generation efficiency, and contamination of surroundings are prevented.

A dye-sensitized solar cell electrode of the present invention includes a substrate, a conductive layer that is formed on one side surface of the substrate and is surrounded by a sealing layer for sealing in an electrolyte, a current collecting layer formed on the other side surface of the substrate, and a conductive portion that allows electrical conduction between the conductive layer and the current collecting layer in the thickness direction of the substrate.

Furthermore, it is preferable that, in the dye-sensitized solar cell electrode of the present invention, the current collecting layer is disposed so as to traverse the sealing layer when projected in the thickness direction of the substrate.

Furthermore, it is preferable that, in the dye-sensitized solar cell electrode of the present invention, the substrate is formed with an opening that extends through in the thickness direction, and the conductive portion fills in the opening.

Furthermore, it is preferable that, in the dye-sensitized solar cell electrode of the present invention, the conductive layer is provided in a plural number per one current collecting layer.

Furthermore, it is preferable that, in the dye-sensitized solar cell electrode of the present invention, the conductive portion is provided in a plural number per one conductive layer.

Furthermore, it is preferable that, in the dye-sensitized solar cell electrode of the present invention, the current collecting layer includes a current collecting wiring formed continuously with the conductive portion, and a current collecting terminal formed continuously with the current collecting wiring, wherein the current collecting terminal is provided on one side surface of the substrate.

Furthermore, it is preferable that, in the dye-sensitized solar cell electrode of the present invention, the current collecting layer includes a current collecting wiring formed continuously with the conductive portion, and a current collecting terminal formed continuously with the current collecting wiring, wherein the current collecting terminal is provided on the other side surface of the substrate.

A dye-sensitized solar cell of the present invention includes a working electrode, a counter electrode disposed to face the working electrode with a space provided therebetween, a sealing layer disposed between the working electrode and the counter electrode, and an electrolyte that fills in between the working electrode and the counter electrode and is sealed in by the sealing layer, wherein the working electrode and/or the counter electrode is the above-described dye-sensitized solar cell electrode.

In the dye-sensitized solar cell electrode of the present invention, the conductive portion allows electrical connection between the conductive layer and the current collecting layer in the thickness direction of the substrate.

Therefore, in the dye-sensitized solar cell of the present invention in which the dye-sensitized solar cell electrode of the present invention is used as the working electrode and/or the counter electrode, without necessitating penetration of the sealing layer by the current collecting layer, excellent sealing performance of the sealing layer against the electrolyte can be ensured, and at the same time, generated electricity can be taken out more efficiently from the conductive layer via the conductive portion by the current collecting layer.

Therefore, the dye-sensitized solar cell of the present invention can prevent a reduction in power generation efficiency and contamination of surroundings.

### Brief Description of the Drawings

FIG. 1 shows a plan view of an embodiment of a dye-sensitized solar cell of the present invention.
FIG. 2 shows a cross-sectional view taken along line II-II of the dye-sensitized solar cell in FIG. 1.
FIG. 3 shows a cross-sectional view taken along line III-III of the dye-sensitized solar cell in FIG. 1.
FIG. 4 shows a cross-sectional view of a counter electrode as an embodiment of the dye-sensitized solar cell electrode of the present invention.
FIG. 5 shows production process drawings for describing a method for producing the counter electrode shown in FIG. 4:
   (a) illustrating a step of preparing a two-layer substrate,
   (b) illustrating a step of forming a cathode-side opening,
   (c) illustrating a step of forming an etching resist,
   (d) illustrating a step of etching a conductive foil,
   (e) illustrating a step of removing the etching resist, and
   (f) illustrating a step of forming a plating resist.

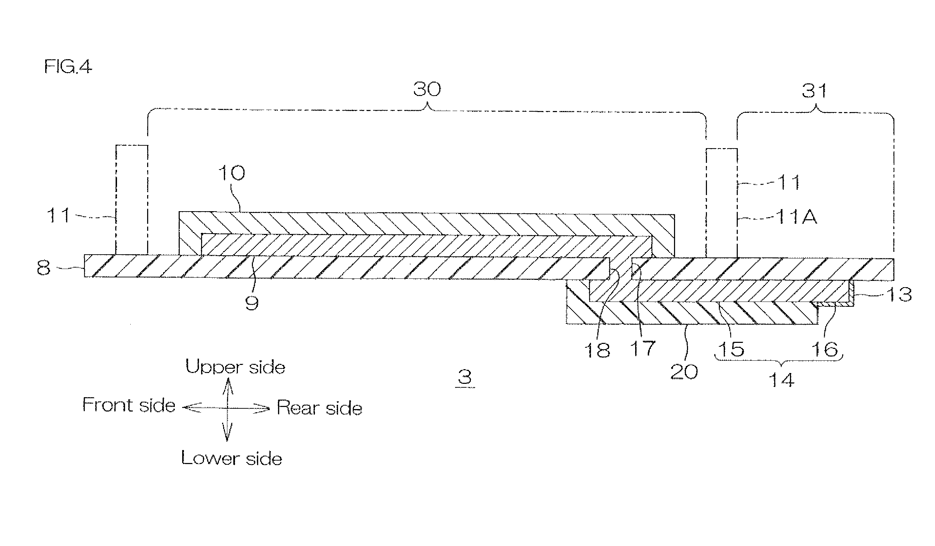

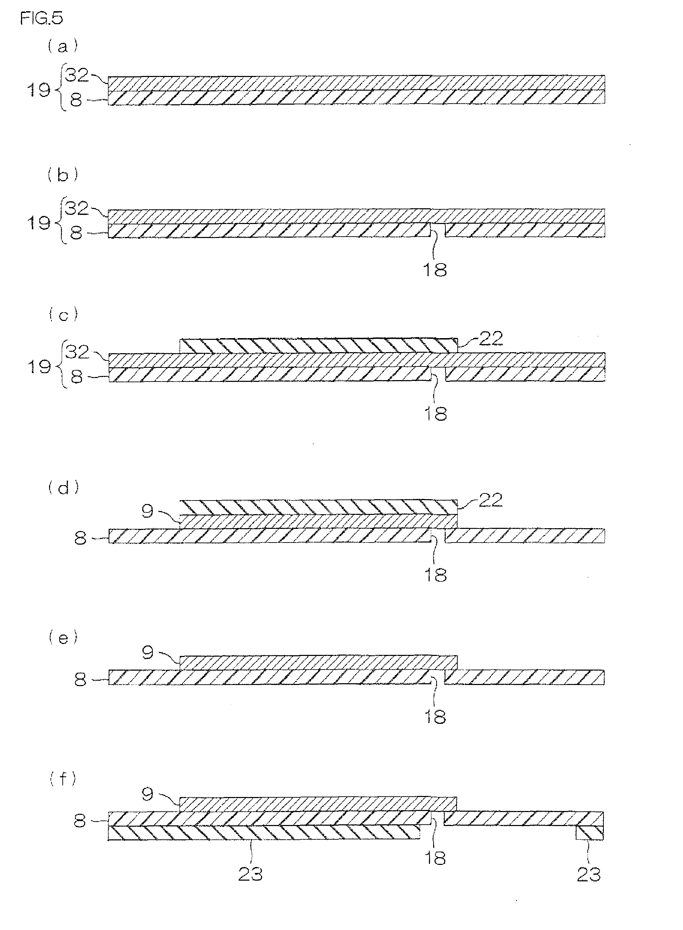

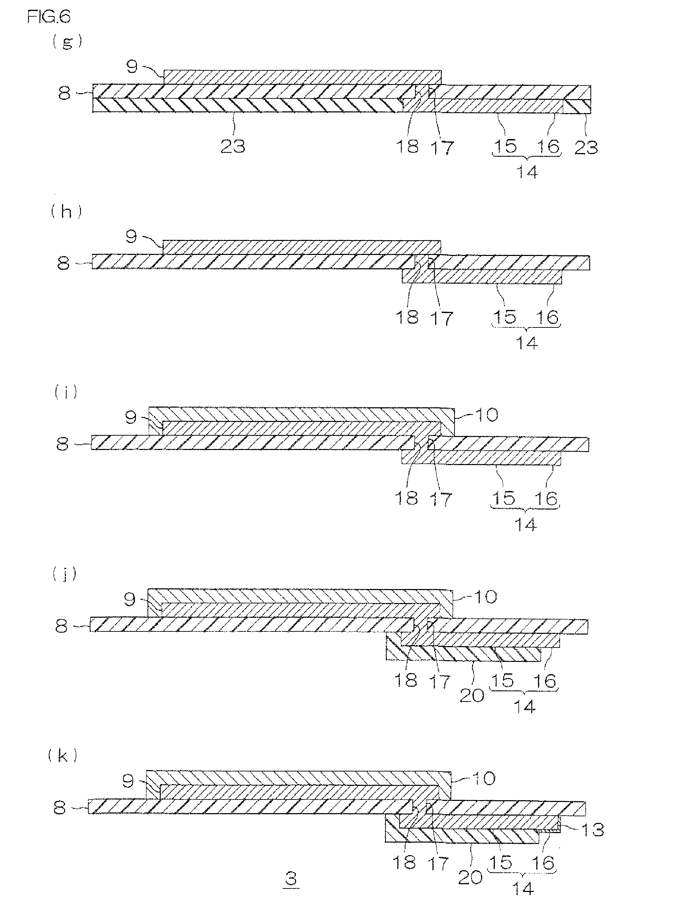

FIG. 6 shows, subsequent to FIG. 5, production process drawings for describing a method for producing the counter electrode shown in FIG. 4:
   (g) illustrating a step of forming a cathode-side conductive portion and a cathode-side current collecting layer,
   (h) illustrating a step of removing the plating resist,
   (i) illustrating a step of forming a catalyst layer,
   (j) illustrating a step of forming a cathode-side cover layer, and
   (k) illustrating a step of forming a first protection layer.

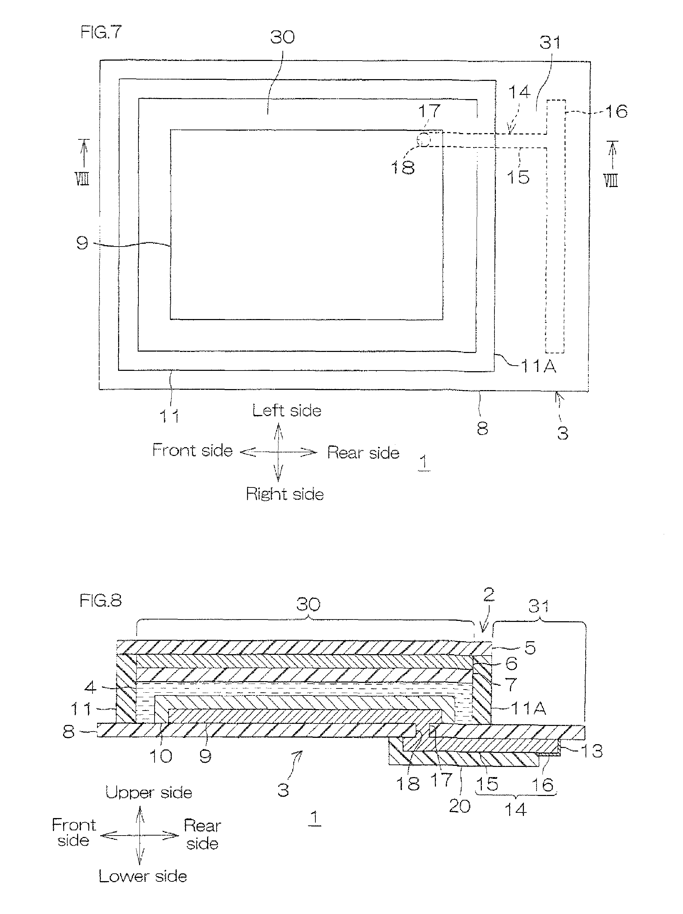

FIG. 7 shows a plan view of another embodiment (embodiment in which one cathode-side conductive layer is provided per one cathode-side current collecting layer) of the dye-sensitized solar cell of the present invention.
FIG. 8 shows a cross-sectional view taken along line VIII-VIII of the dye-sensitized solar cell in FIG. 7.

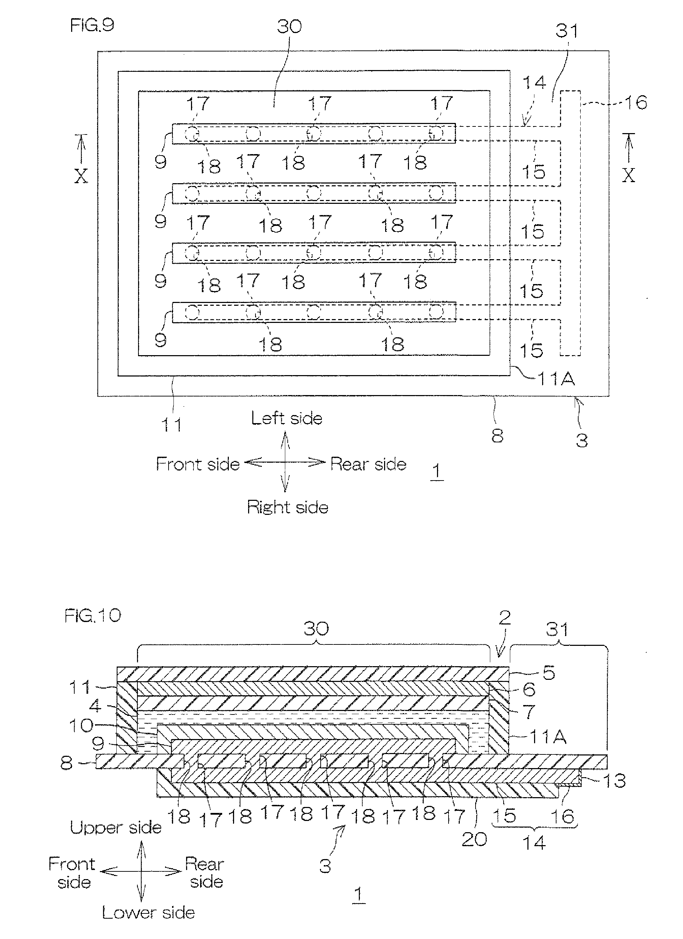

FIG. 9 shows a plan view of another embodiment (embodiment in which a plurality of cathode-side conductive portions are provided per one cathode-side conductive layer) of the dye-sensitized solar cell of the present invention.
FIG. 10 shows a cross-sectional view taken along line X-X of the dye-sensitized solar cell in FIG. 9.

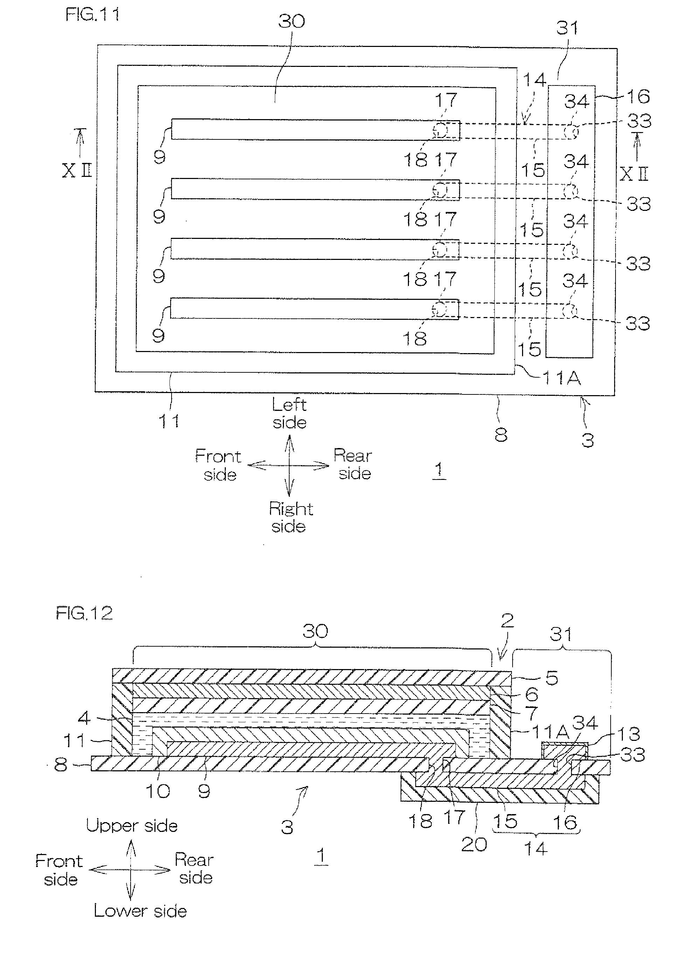

FIG. 11 shows a plan view of another embodiment (embodiment in which the cathode-side current collecting terminal is provided on one side surface of the cathode-side substrate) of the dye-sensitized solar cell of the present invention.
FIG. 12 shows a cross-sectional view taken along line XII-XII of the dye-sensitized solar cell in FIG. 11.

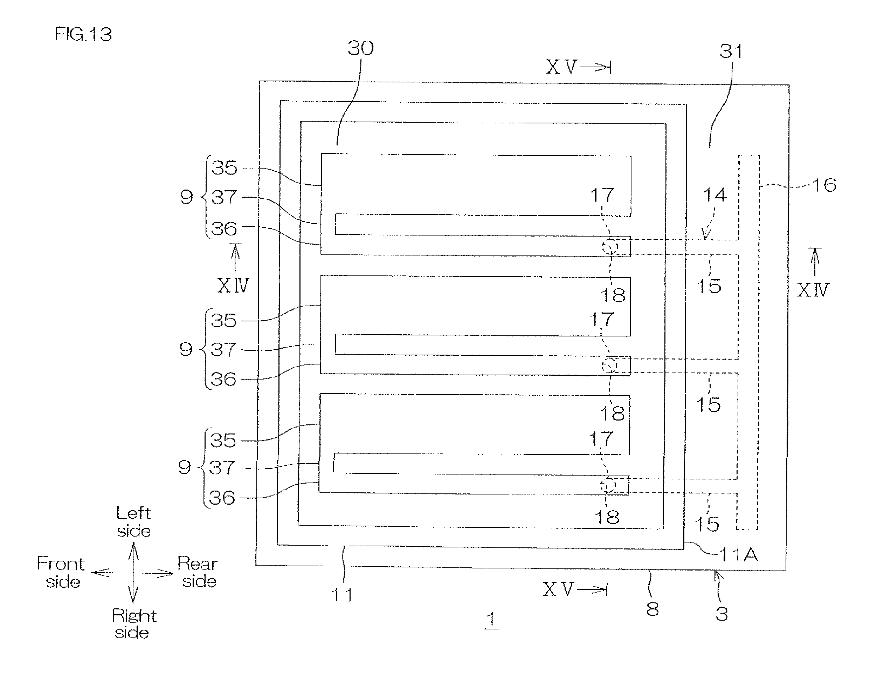

FIG. 13 shows a cross-sectional view of another embodiment (embodiment in which the cathode-side conductive layer includes a current collecting region) of the dye-sensitized solar cell of the present invention.

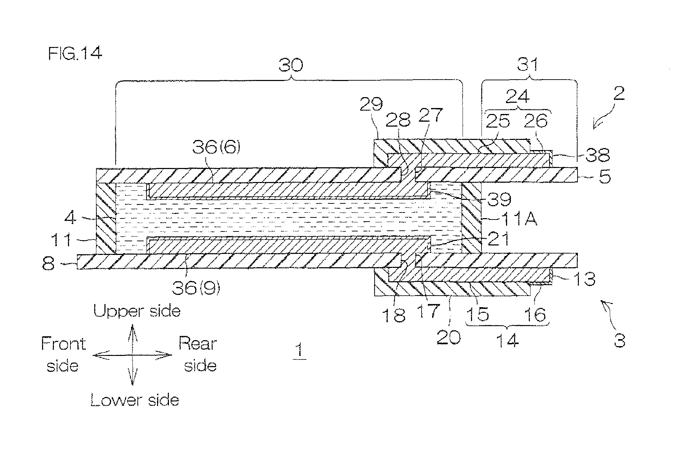

FIG. 14 shows a cross-sectional view taken along line XIV-XIV of the dye-sensitized solar cell (embodiment in which the anode-side conductive portion and the cathode-side conductive portion are provided at the working electrode and the counter electrode, respectively) in FIG. 13.

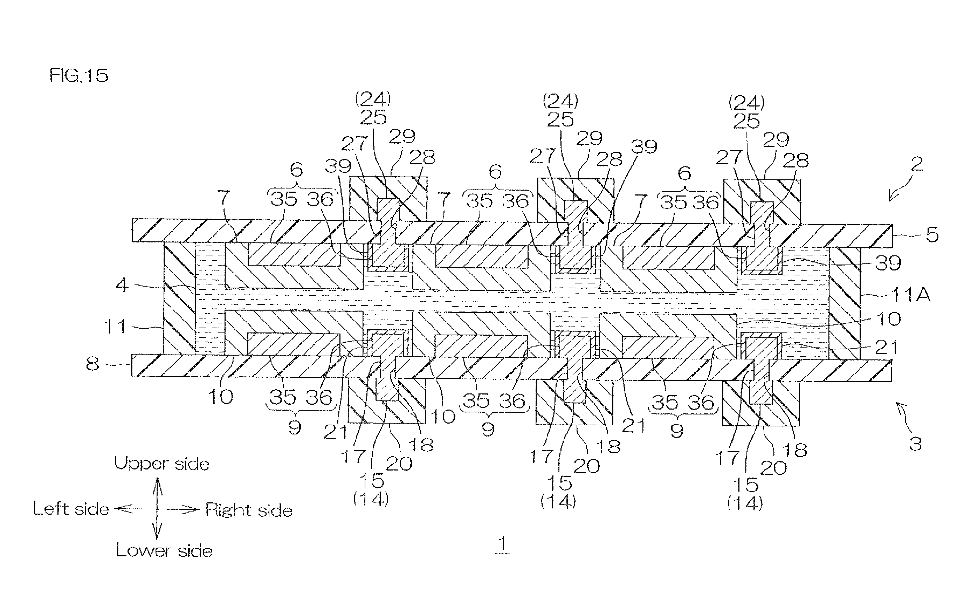

FIG. 15 shows a cross-sectional view taken along line XV-XV of the dye-sensitized solar cell (embodiment in which the anode-side conductive portion and the cathode-side conductive portion are provided at the working electrode and the counter electrode, respectively) in FIG. 13.

### DETAILED DESCRIPTION OF THE INVENTION

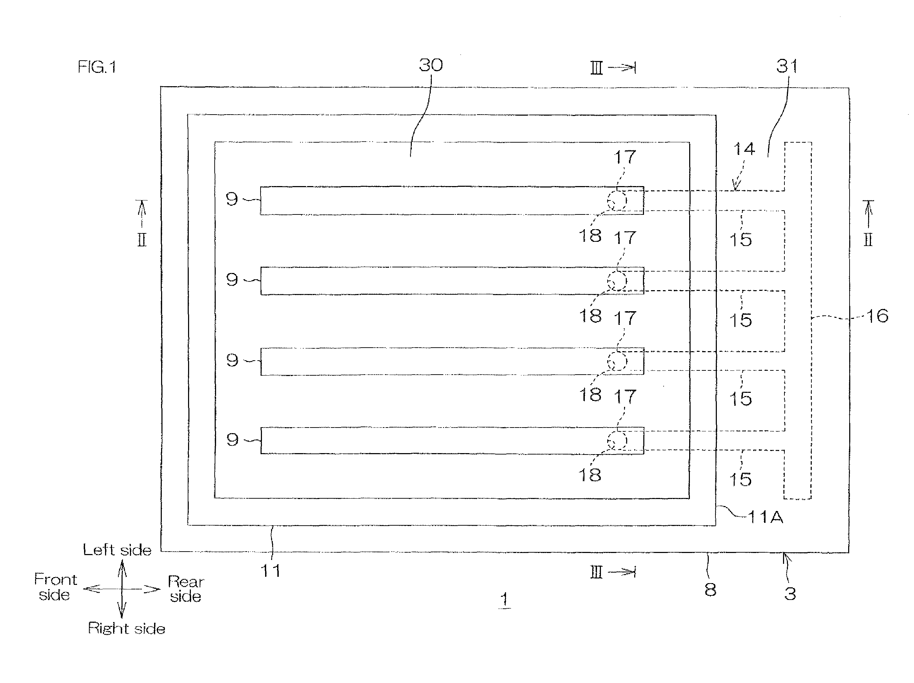

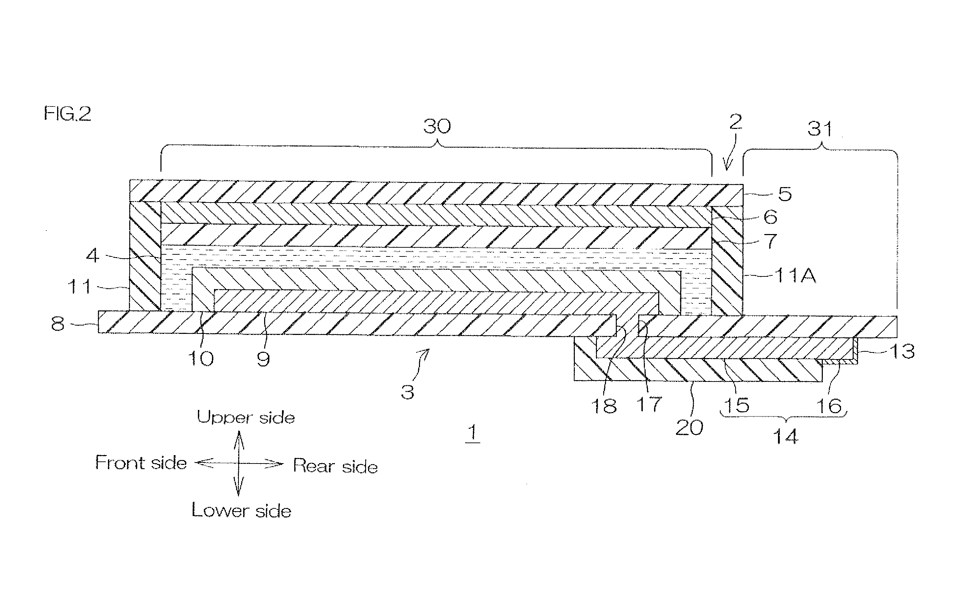

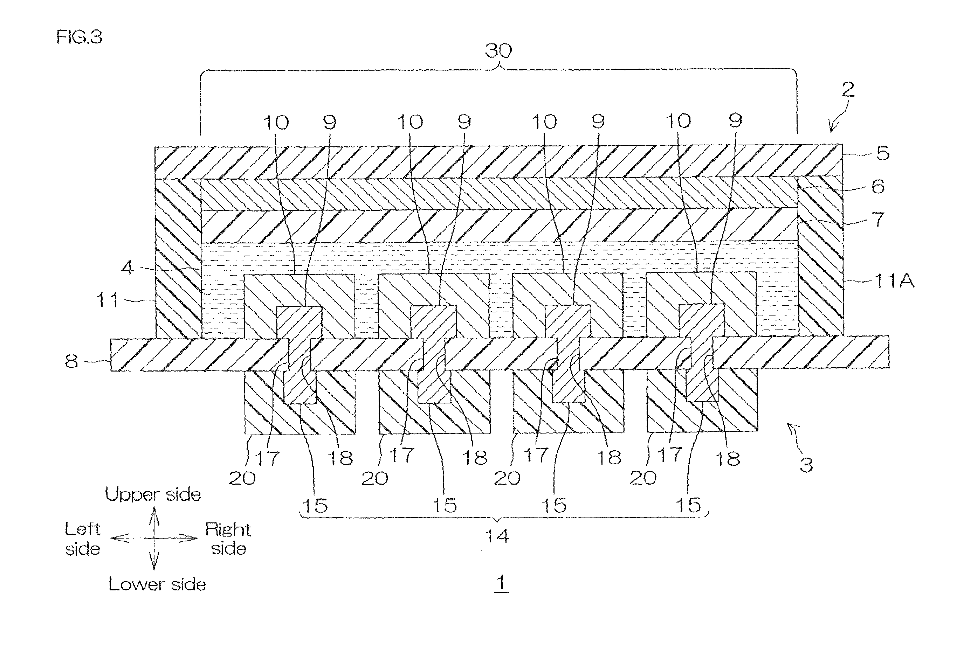

FIG. 1 shows a plan view of an embodiment of the dye-sensitized solar cell of the present invention; FIG. 2 shows a cross-sectional view taken along line II-II of the dye-sensitized solar cell in FIG. 1; FIG. 3 shows a cross-sectional view taken along line III-III of the dye-sensitized solar cell in FIG. 1; FIG. 4 shows a cross-sectional view of a counter electrode as an embodiment of the dye-sensitized solar cell electrode of the present invention; and FIGs. 5 and 6 show production process drawings for describing a method for producing the counter electrode shown in FIG. 4.

In FIG. 1, a working electrode 2 is omitted so as to clearly show relative positions of a cathode-side conductive layer 9 and a cathode-side current collecting layer 14 of a counter electrode 3. In FIG. 1, the left side on the plane of the sheet is referred to as "front side"; the right side on the plane of the sheet is referred to as "rear side"; the upper side on the plane of the sheet is referred to as "left side"; the lower side on the plane of the sheet is referred to as "right side"; and directions in FIG. 2 and the subsequent figures are in accordance with the above-described directions in FIG. 1.

In FIGs. 1 to 3, a dye-sensitized solar cell 1 inclucles a working electrode 2 (anode); a counter electrode 3 (cathode, opposing electrode) that is disposed therebelow to face the working electrode 2 with a space provided therebetween; a sealing layer 11 that is disposed between the working electrode 2 and the counter electrode 3; and an electrolyte 4 that fills in between the working electrode 2 and the counter electrode 3.

The working electrode 2 has a photosensitizing function, and is formed into a generally flat plate shape. The working electrode 2 includes an anode-side substrate 5, an anode-side conductive layer 6 laminated below the anode-side substrate 5, and a dye-sensitized semiconductor layer 7 laminated below the anode-side conductive layer 6.

The anode-side substrate 5 is transparent, and formed into a flat plate shape. For example, the anode-side substrate 5 is formed from an insulating plate or an insulating film, examples of which include a rigid plate such as a glass substrate and a flexible film such as a plastic film.

Examples of the plastic material that forms the plastic film include polyester resins (excluding liquid crystal polymer to be described later) such as polyethylene terephthalate (PET), polybutylene terephthalate, and polyethylene-2,6-naphthalate (PEN); liquid crystal polymers such as thermotropic liquid crystal polyester and thermotropic liquid crystal polyesteramide; acrylic resins such as polyacrylate and polymethacrylate; olefin resins such as polyethylene and polypropylene; vinyl resins such as polyvinyl chloride, an ethylene-vinyl acetate copolymer, and an ethylene-vinylalcohol copolymer; imide resins such as polyimide and polyamide-imide; and ether resins such as polyethernitrile and polyether sulfone. These plastic materials may be used alone, or may be used in combination of two or more.

The thickness of the anode-side substrate 5 is, for example, 5 to 500 µm, or preferably 10 to 400 µm.

The anode-side conductive layer 6 is made of, for example, a transparent conductive thin film, and is formed on the lower face (facing side or surface that faces the electrolyte 4) of the anode-side substrate 5. To be more specific, the anode-side conductive layer 6 is formed at a center in the front-rear direction and in the left-right direction of the lower face of the anode-side substrate 5 so as to expose the peripheral end portion of the lower face of the anode-side substrate 5.

Examples of the conductive materials that form the transparent conductive thin film include metal materials such as gold, silver, copper, platinum, nickel, tin, aluminum, and alloys thereof (for example, copper alloy); metal oxide (composite oxide) materials such as tin-doped indium oxide (ITO), fluorine-doped tin oxide (FTO), and zinc-doped indium oxide (IZO); and a carbon material such as carbon. These conductive materials may be used alone, or may be used in combination of two or more.

The thickness of the anode-side conductive layer 6 is, for example, 0.01 to 100 µm, or preferably 0.1 to 10 µm.

The dye-sensitized semiconductor layer 7 is formed on the entire face of the lower face (facing side or surface that faces the electrolyte 4) of the anode-side conductive layer 6.

The dye-sensitized semiconductor layer 7 is formed by laminating dye-sensitized semiconductor particles into a sheet. Such dye-sensitized semiconductor particles are, for example, porous semiconductor particles composed of metal oxide to which dye is adsorbed.

Examples of the metal oxide include titanium oxide, zinc oxide, tin oxide, tungsten oxide, zirconium oxide, hafnium oxide, strontium oxide, indium oxide, yttrium oxide, lanthanum oxide, vanadium oxide, niobium oxide, tantalum oxide, chromium oxide, molybdenum oxide, iron oxide, nickel oxide, and silver oxide. A preferable example is titanium oxide.

Examples of the dye include metal complexes such as a ruthenium complex and a cobalt complex; and organic dyes such as a cyanine dye, a merocyanine dye, a phthalocyanine dye, a coumarin dye, a riboflavin dye, a xanthene dye, a triphenylmethane dye, an azo dye, and a chinone dye. Preferable examples are a ruthenium complex and a merocyanine dye.

The average particle size of the dye-sensitized semiconductor particles is, on the primary particle size basis, for example, 5 to 200 nm, or preferably 8 to 100 nm.

The thickness of the dye-sensitized semiconductor layer 7 is, for example, 0.4 to 100 µm, preferably 0.5 to 50 µm, or more preferably 0.5 to 15 µm.

The counter electrode 3, which is to be described in detail later, is formed into a generally flat plate shape.

The sealing layer 11 is disposed, between the working electrode 2 and the counter electrode 3, at the peripheral end portion (both end portions in the front-rear direction and both end portions in the left-right direction) of the dye-sensitized solar cell 1, and is formed into a generally rectangular frame shape when projected in the thickness direction. To be more specific, the sealing layer 11 is formed of a pair of front-rear beams (front beam and rear beam 11A) extending in the left-right direction and being parallel to each other with a space provided therebetween in the front-rear direction; and a pair of left-right beams (left beam and right beam) being connected to the pair of front-rear beams and extending in parallel in the front-rear direction.

The sealing layer 11 is adjacent to both end portions in the left-right direction and to both end portions in the front-rear direction of the anode-side conductive layer 6 and the dye-sensitized semiconductor layer 7.

Examples of the sealing material that forms the sealing layer 11 include a silicone resin, an epoxy resin, a polyisobutylene-based resin, a hot-melt resin, and fritted glass. These sealing materials may be used alone, or may be used in combination of two or more.

The sealing layer 11 is prepared, for example, as a resin composition containing the above-described sealing material as a main component.

The thickness of the sealing layer 11 (the length in the up-down direction) is, for example, 5 to 500 µm, preferably 5 to 100 µm, or more preferably 10 to 50 µm.

The width of the sealing layer 11 (length in the front-rear direction of the front-rear beams, and length in the left-right direction of the left-right beams) is, for example, 0.1 to 20 mm, or preferably 1 to 5 mm.

The electrolyte 4 is sealed in by the sealing layer 11 between the working electrode 2 and the counter electrode 3. The electrolyte 4 is prepared, for example, as a fluid (flowable) such as a solution (liquid electrolyte) in which the electrolyte 4 is dissolved in a solvent, or as a gel electrolyte in which the solution is gelled.

The electrolyte 4 contains, as a main component, iodine, and/or a combination of iodine and an iodine compound (redox system).

Examples of the iodine compound include metal iodides such as lithium iodide (LiI), sodium iodide (NaI), potassium iodide (KI), cesium iodide (CsI), and calcium iodide (CaI₂); and organic quaternary ammonium iodide salts such as tetraalkyl ammonium iodide, imidazolium iodide, and pyridinium iodide.

The electrolyte 4 may also include, as accessory components, for example, a halogen (excluding iodine) such as bromine; or a combination of a halogen and a halogen compound (excluding a combination of iodine and an iodine compound) such as a combination of bromine and a bromine compound.

Examples of the solvent include organic solvents, and an aqueous solvent such as water. Examples of the organic solvents include carbonate compounds such as dimethyl carbonate, diethyl carbonate, methyl ethyl carbonate, ethylene carbonate, and propylene carbonate; ester compounds such as methyl acetate, methyl propionate, and gamma-butyrolactone; ether compounds such as diethylether, 1,2-dimethoxyethane, 1,3-dioxolane, tetrahydrofuran, and 2-methyl-tetrahydrofuran; heterocyclic compounds such as 3-methyl-2-oxazolidinone; and 2-methylpyrrolidone; nitrile compounds such as acetonitrile, methoxyacetonitrile, propionitrile, and 3-methoxypropionitrile; and aprotic polar compounds such as sulfolane, dimethyl sulfoxide, and dimethyl formamide. A preferable example is an organic solvent, and a more preferable example is a nitrile compound.

The proportion of the electrolyte content relative to 100 parts by weight of the liquid electrolyte is, for example, 0.001 to 10 parts by weight, or preferably 0.01 to 1 parts by weight. Although it depends on the molecular weight of the electrolyte, the electrolyte concentration in the electrolyte 4 may be set to, on the normality basis, for example, 0.001 to 10 M, or preferably 0.01 to 1 M.

The gel electrolyte is prepared by adding, for example, a known gelling agent at an appropriate ratio into a liquid electrolyte.

Examples of the gelling agent include a low molecular weight gelling agent such as a natural higher fatty acid, and polysaccharides such as amino acid compounds; and a high molecular weight gelling agent such as a fluorine-based polymer (for example, polyvinylidene fluoride, a vinylidene fluoride-hexafluoropropylene copolymer, etc.), and a vinyl-based polymer (for example, polyvinyl acetate, polyvinyl alcohol, etc.).

In the dye-sensitized solar cell 1, as shown in FIG. 4, the counter electrode 3 as an embodiment of the dye-sensitized solar cell electrode of the present invention is used.

The counter electrode 3 includes, a cathode-side substrate 8 as the substrate; a cathode-side conductive layer 9 as the conductive layer formed on the upper face of the cathode-side substrate 8 (facing side or surface that faces the electrolyte 4); a cathode-side current collecting layer 14 as the current collecting layer formed on the lower face (opposite side or reverse side of the facing side that faces the electrolyte 4) of the cathode-side substrate 8; and a cathode-side conductive portion (first conductive portion) 17 as the conductive portion. The counter electrode 3 includes a catalyst layer 10, a cathode-side cover layer 20, and a first protection layer 13.

The cathode-side substrate 8 is formed into a flat plate shape. To be more specific, the cathode-side substrate 8 is formed to include, when projected in the thickness direction, the sealing layer 11, and the cathode-side conductive layer 9 and cathode-side current collecting layer 14 to be described next.

The cathode-side substrate 8 is sectioned by the above-described sealing layer 11, when projected in the thickness direction, into a seal region 30 that seals in the electrolyte 4, and a take-out region 31, described later, in which electricity is taken out from the counter electrode 3.

The seal region 30 is defined, as shown in FIG. 1, as a region surrounded by the sealing layer 11 when viewed from the top.

The take-out region 31 is defined as a region on the outside of the sealing layer 11, mainly as a region at a rear side of the rear beam 11A of the sealing layer 11 when viewed from the top.

The cathode-side substrate 8 is formed with a cathode-side opening (first opening) 18 as an opening that extends through in the thickness direction (up-down direction).

The cathode-side opening 18 is provided at a rear end portion in the seal region 30 of the cathode-side substrate 8, and a plurality (four) of cathode-side openings 18 are formed in correspondence with cathode-side conductive portions 17 to be described later with a space provided therebetween in the left-right direction. The cathode-side openings 18 are formed into a generally circular shape when viewed from the top.

Examples of the material that forms the cathode-side substrate 8 include the material that forms the anode-side substrate 5 (ref: FIGs. 2 and 3). In view of handleability, a plastic material is a preferable example.

The thickness of the cathode-side substrate 8 is, for example, 5 to 50 µm, or preferably 12.5 to 25 µm. The maximum length (inner diameter) of the cathode-side opening 18 is, for example, 5 to 50 µm, or preferably 12.5 to 30 µm.

The cathode-side conductive layer 9 is provided on the upper face of the cathode-side substrate 8 in the seal region 30. That is, the cathode-side conductive layer 9 is surrounded by the sealing layer 11 on the upper face of the cathode-side substrate 8. The cathode-side conductive layer 9 is formed into a conductive pattern including a plurality (four) of cathode-side conductive layers extending in the front-rear direction with a space provided therebetween in the left-right direction. The rear end portion of the cathode-side conductive layers 9 are disposed to include the cathode-side openings 18 when projected in the thickness direction.

Examples of the conductive material that forms the cathode-side conductive layer 9 include the conductive material for the above-described anode-side conductive layer 6.

The thickness of the cathode-side conductive layer 9 is, for example, 2 to 70 µm, or preferably 5 to 35 µm.

The cathode-side current collecting layer 14 is provided, as shown in FIG. 1 (broken line) and FIG. 4, so as to be continuous through the lower face of both of the seal region 30 and the take-out region 31 of the cathode-side substrate 8, and is formed into a generally comb shape that opens forward when projected in the thickness direction. The cathode-side current collecting layer 14 is formed into a current collecting pattern including cathode-side current collecting wirings 15 and cathode-side current collecting terminals 16.

The cathode-side current collecting wirings 15 are formed in correspondence with the cathode-side conductive layers 9. To be more specific, a plurality (four) of cathode-side current collecting wirings 15 are formed, so as to extend in the front-rear direction in the seal region 30 and the take-out region 31 with a space provided therebetween in the left-right direction.

To be specific, the cathode-side current collecting wiring 15 is formed so that the front end portion thereof is disposed below the cathode-side opening 18 in the seal region 30, and the rear end portion thereof is disposed below the take-out region 31. The front end portion of the cathode-side current collecting wiring 15 includes, when projected in the thickness direction, the cathode-side opening 18.

The cathode-side current collecting wiring 15 is disposed so that its middle portion in the front-rear direction traverses the rear beam 11A so as to cross at right angles (intersect) with the rear beam 11A of the sealing layer 11 when projected in the thickness direction.

Meanwhile, the cathode-side current collecting wiring 15 is disposed with a space provided between the cathode-side current collecting wiring 15 and the rear beam 11A in the up-down direction when projected in the left-right direction. That is, the middle portion of the cathode-side current collecting wiring 15 in the front-rear direction is formed so as to sandwich the cathode-side substrate 8 with the rear beam 11A in the thickness direction.

The cathode-side current collecting terminal 16 is provided on a lower face of the cathode-side substrate 8 in the take-out region 31. The cathode-side current collecting terminal 16 is formed into a straight line extending in the left-right direction, and is formed continuously with the cathode-side current collecting wiring 15. That is, at the front end of the cathode-side current collecting terminal 16, the rear end of the cathode-side current collecting wiring 15 is connected to form a generally T-shape when viewed from the bottom.

Examples of the conductive material that forms the cathode-side current collecting layer 14 include the above-described conductive material for the anode-side conductive layer 6.

The thickness of the cathode-side current collecting layer 14 is, for example, 0.1 to 100 µm, or preferably 1 to 50 µm.

The cathode-side conductive portion 17 fills in the cathode-side opening 18. To be more specific, the cathode-side conductive portions 17 are formed continuously with the cathode-side conductive layers 9 and the cathode-side current collecting wirings 15.

In this way, the cathode-side conductive portion 17 allows electrical conduction between the cathode-side conductive layer 9 and the cathode-side current collecting layer 14 in the thickness direction of the cathode-side substrate 8.

Examples of the conductive material that forms the cathode-side conductive portion 17 include the above-described conductive material for the anode-side conductive layer 6 (ref: FIG. 2).

The catalyst layer 10 is formed, as shown in FIGs. 2 to 4, on the surface (facing side that faces the electrolyte 4) of the cathode-side conductive layer 9. To be specific, the catalyst layer 10 is formed, above the cathode-side substrate 8, continuously on the both front-rear side faces, the both left-right side faces, and the upper face of the cathode-side conductive layer 9.

Examples of the catalyst material that forms the catalyst layer 10 include noble metal materials such as platinum, ruthenium, and rhodium; conductive organic materials such as polydioxythiophene and polypyrrole; metal oxide materials such as ITO, FTO, and IZO; and a carbon material such as carbon. Preferable examples are platinum and carbon. These materials may be used alone, or may be used in combination of two or more.

The thickness of the catalyst layer 10 is, for example, 50 nm to 100 µm, or preferably 100 nm to 50 µm.

The cathode-side cover layer 20 is formed, below the cathode-side substrate 8, so as to cover the reverse side (opposite side of the facing side that faces the electrolyte 4) of the cathode-side current collecting wiring 15, and to expose the reverse side (lower face and side face) of the cathode-side current collecting terminal 16. To be more specific, the cathode-side cover layer 20 is formed continuously on the front side face, the both left-right side faces, and the bottom face of the cathode-side current collecting wiring 15.

Examples of the material that forms the cathode-side cover layer 20 include the above-described imide resins, and an insulation material such as a solder resist.

The thickness of the cathode-side cover layer 20 is, for example, 0.2 to 50 µm, or preferably 5 to 30 µm.

The first protection layer 13 covers, as shown in FIGs. 2 and 4, the surface (opposite side of the facing side that faces the electrolyte 4) of the cathode-side current collecting terminal 16 at below the cathode-side substrate 8. To be more specific, the first protection layer 13 is formed continuously on the rear side face, the both left-right side faces, and the lower face of the cathode-side current collecting terminal 16.

Examples of the material that forms the first protection layer 13 include anticorrosive materials such as nickel, gold, chromium, and alloys thereof; and water-soluble flux materials (flux) such as an azole compound and a benzimidazole compound. These materials may be used alone, or may be used in combination.

The thickness of the first protection layer 13 is, for example, 0.01. to 10 µm, or preferably 0.05 to 5 µm.

To produce the dye-sensitized solar cell 1, first, the working electrode 2, the counter electrode 3, the sealing layer 11, and the electrolyte 4 are prepared (or made).

The working electrode 2 is made by sequentially laminating the anode-side substrate 5, the anode-side conductive layer 6, and the dye-sensitized semiconductor layer 7 downward.

The sealing layer 11 is prepared, for example, as the above-described resin composition.

The electrolyte 4 is prepared as the above-described liquid electrolyte or a gelled electrolyte.

The counter electrode 3 is prepared in accordance with the method below as shown in FIGs. 5 and 6.

That is, first, as shown in FIG. 5 (a), the two-layer substrate 19 including the cathode-side substrate 8, and a conductive foil (first conductive foil) 32 laminated thereon is prepared.

In the two-layer substrate 19, the conductive foil 32 is formed on the entire upper face of the cathode-side substrate 8.

Then, as shown in FIG. 5 (b), the cathode-side opening 18 is formed in the cathode-side substrate 8.

The cathode-side opening 18 is formed, for example, by a known method such as etching and perforation processing.

In this fashion, the cathode-side substrate 8 which is formed with the cathode-side opening 18 is formed in the two-layer substrate 19.

Then, as shown in as shown in FIG. 5(c), the etching resist 22 is formed on the upper face of the conductive foil 32.

The etching resist 22 is formed into a pattern that is the same as that of the above-described cathode-side conductive layer 9, by laminating a dry film resist (not shown) on the entire upper face of the conductive foil 32, exposing the resist to light, and developing the resist.

Then, as shown in FIG. 5(d), the conductive foil 32 exposing from the etching resist 22 is subjected to a chemical etching using an etching solution such as, for example, an aqueous solution of ferric chloride.

Thereafter, as shown in FIG. 5 (e), the etching resist 22 is removed by etching or peeling.

In this fashion, the cathode-side conductive layer 9 is formed into the above-described conductive pattern (subtractive method).

Then, although not shown, a thin conductive film (seed film) is formed on the lower face (including the inner circumferential surface of the cathode-side opening 18 and the lower face of the cathode-side conductive layer 9 exposing from the cathode-side opening 18) of the cathode-side substrate 8. The thin conductive film is made of, for example, a conductive material such as copper, nickel, and chromium, and is formed, for example, by sputtering.

Subsequently, as shown in FIG. 5(f), the plating resist 23 is formed into a pattern that is reverse to the current collecting pattern of the cathode-side current collecting layer 14 at the lower face of the thin conductive film, which is not shown. The plating resist 23 is formed into the above-described pattern by laminating a dry film resist below the entire lower face of the cathode-side substrate 8, then exposing the resist to light, and developing the resist.

Then, as shown in FIG. 6(g), the cathode-side conductive portion 17 and the cathode-side current collecting layer 14 are simultaneously formed on the lower face of the thin conductive film (not shown) exposing from the plating resist 23 by, for example, plating such as electrolytic plating and electroless plating.

Thereafter, as shown in FIG. 6(h), the plating resist 23 and the portion of the thin conductive film (not shown) where the plating resist 23 was laminated are removed.

In this fashion, the cathode-side conductive portion 17 and the cathode-side current collecting layer 14 are simultaneously formed into the above-described pattern (additive method).

Then, as shown in FIG. 6(i), the catalyst layer 10 is formed so as to cover the cathode-side conductive layer 9.

The catalyst layer 10 is formed, for example, by a printing method, a spraying method, or a physical vapor deposition method, into the above-described pattern.

In the printing method, for example, a paste containing microparticles of the above-described catalyst material is screen printed on the surface of the cathode-side conductive layer 9, into the above-described pattern.

In the spraying method, for example, a dispersion of the above-described catalyst material microparticles dispersed in a known dispersion medium is prepared first. Also, a mask having a predetermined pattern of opening is used to cover the upper face of the cathode-side substrate 8. Afterwards, from above the cathode-side substrate 8 and the mask, the prepared dispersion is blown (sprayed). Afterwards, the mask is removed and the dispersion medium is evaporated.

As the physical vapor deposition method, sputtering is preferably used. To be specific, after covering the upper face of the cathode-side substrate 8 with a mask having a predetermined pattern of opening, sputtering is performed from above using, for example, a catalyst material as a target, and then the mask is removed.

When the catalyst layer 10 is to be formed from a noble metal material, preferably, the physical vapor deposition (for example, vacuum deposition, sputtering, etc.) is used, and when the catalyst layer 10 is to be formed from a carbon material, preferably, the printing method or spraying method is used.

Then, as shown in FIG. 6(j), the cathode-side cover layer 20 is formed into a pattern that covers the cathode-side current collecting wiring 15.

To form the cathode-side cover layer 20, for example, a varnish of photosensitive insulation material and solder resist is applied on the entire lower face of the cathode-side substrate 8 including the cathode-side current collecting layer 14, dried, exposed to light through a photomask, developed, and then cured as necessary.

Afterwards, as shown in FIG. 6(k), the first protection layer 13 is formed into a pattern that covers the cathode-side current collecting terminal 16.

The first protection layer 13 is formed, for example, by sputtering or plating the above-described anticorrosive material, or by immersion in an aqueous solution of the above-described water-soluble flux material.

The counter electrode 3 is thus made.

Then, the working electrode 2 and the counter electrode 3 are disposed so that the dye-sensitized semiconductor layer 7 and the catalyst layer 10 face each other with a space provided therebetween. At the same time, by disposing the resin composition between the working electrode 2 and the counter electrode 3, the sealing layer 11 is provided. Then, by filling the seal region 30 with the electrolyte 4, the electrolyte 4 is sealed in between the working electrode 2 and the counter electrode 3 by the sealing layer 11.

The dye-sensitized solar cell 1 can be produced in this manner.

Then, in the counter electrode 3 of the thus obtained dye-sensitized solar cell 1, the cathode-side conductive portion 17 allows electrical connection between the cathode-side conductive layer 9 and the cathode-side current collecting layer 14 in the thickness direction of the cathode-side substrate 8.

Therefore, in the dye-sensitized solar cell 1 in which the counter electrode 3 is used, excellent sealing performance of the sealing layer 11 against the electrolyte 4 can be ensured without necessitating penetration of the sealing layer 11, in particular, without penetration of the rear beam 11A by the cathode-side conductive layer 9. At the same time, generated electricity can be efficiency taken out from the cathode-side conductive layer 9 via the cathode-side conductive portion 17 and cathode-side current collecting wiring 15 at the cathode-side current collecting terminal 16.

Thus, with the dye-sensitized solar cell 1, a reduction in power generation efficiency and contamination of surroundings can be prevented.

Although the cathode-side conductive layer 9 is formed by the subtractive method in the above-description, the cathode-side conductive layer 9 can also be formed, for example, by a known patterning method such as the additive method.

In the additive method, although not shown, first, the cathode-side substrate 8 is prepared, and then a thin conductive film is formed on the entire upper face of the cathode-side substrate 8 by sputtering. Afterwards, a plating resist is formed from a dry film resist in a pattern that is reverse to the conductive pattern of the above-described cathode-side conductive layer 9, and then the cathode-side conductive layer 9 is formed by plating. Afterwards, the plating resist and the portion of the thin conductive film where the plating resist was laminated are removed.

Although the cathode-side conductive portion 17 and the cathode-side current collecting layer 14 are simultaneously formed in the above-description, for example, the cathode-side conductive portion 17 and the cathode-side current collecting layer 14 can also be formed sequentially, although not shown.

That is, instead of the two-layer substrate 19 in FIG. 5 (a), a three-layer substrate including the two-layer substrate 19 and a second conductive foil laminated below the cathode-side substrate 8 of the two-layer substrate 19 is prepared.

Then, at the same time with the formation of the cathode-side opening 18 of FIG. 5 (b), a conductive opening is formed in the second conductive foil at a portion corresponding to the cathode-side opening 18.

Then, in accordance with the subtractive method of FIG. 5 (c) to FIG. 5 (e), the cathode-side conductive layer 9 is formed.

Then, instead of the additive method of the FIG. 5 (f) to FIG. 6 (h), the cathode-side opening 18 is filled with the cathode-side conductive portion 17, for example, with a printing method or plating, and the conductive opening is filled with a conducive material in the same manner as the above-described method. Then, the cathode-side conductive layer 9 is formed by the subtractive method.

Preferably, the cathode-side conductive portion 17 and the cathode-side current collecting layer 14 are simultaneously formed. In this fashion, the cathode-side conductive portion 17 and the cathode-side current collecting layer 14 are formed at once, and therefore connection therebetween becomes more reliable, and a reduction in power generation efficiency can be prevented even more.

Furthermore, adhesiveness between the cathode-side conductive portion 17 and the cathode-side current collecting layer 14 is improved, and therefore leakage of the electrolyte 4 at the boundary therebetween can be prevented even more reliably, and contamination of surroundings of the dye-sensitized solar cell 1 can be prevented even more.

Furthermore, the cathode-side conductive portion 17 and the cathode-side current collecting layer 14 are formed simultaneously, and therefore production steps can be simplified, and mass production and low-cost can be achieved even more.

FIG. 7 shows a plan view of another embodiment (embodiment in which one cathode-side conductive layer is provided per one cathode-side current collecting layer) of the dye-sensitized solar cell of the present invention; FIG. 8 shows a cross-sectional view taken along line VIII-VIII of the dye-sensitized solar cell in FIG. 7; FIG. 9 shows a plan view of another embodiment (embodiment in which a plurality of cathode-side conductive portions are provided per one cathode-side conductive layer) of the dye-sensitized solar cell of the present invention; FIG. 10 shows a cross-sectional view taken along line X-X of the dye-sensitized solar cell in FIG. 9; FIG. 11 shows a plan view of another embodiment (embodiment in which the cathode-side current collecting terminal is provided on one side surface of the cathode-side substrate) of the dye-sensitized solar cell of the present invention; FIG. 12 shows a cross-sectional view taken along line XII-XII of the dye-sensitized solar cell in FIG. 11; FIG. 13 shows a plan view of another embodiment (embodiment in which the cathode-side conductive layer includes a current collecting region) of the dye-sensitized solar cell of the present invention; FIG. 14 shows a cross-sectional view taken along line XIV-XIV of the dye-sensitized solar cell (embodiment in which the anode-side conductive portion and the cathode-side conductive portion are provided at the working electrode and the counter electrode, respectively) in FIG. 13; and FIG. 15 shows a cross-sectional view taken along line XV-XV of the dye-sensitized solar cell (embodiment in which the anode-side conductive portion and the cathode-side conductive portion are provided at the working electrode and the counter electrode, respectively) in FIG. 13.

In FIG. 13, the working electrode 2 is omitted in order to clearly show relative positions of the cathode-side conductive layer 9 and the cathode-side current collecting layer 14 of the counter electrode 3.

Although a plurality (four) of cathode-side conductive layers 9 are provided per one cathode-side current collecting layer 14 in the above-description, for example, as shown in FIGS. 7 and 8, one cathode-side conductive layer 9 may also be provided per one cathode-side current collecting layer 14.

In FIGs. 7 and 8, the cathode-side conductive layer 9 is formed into a generally rectangular flat plate shape when viewed from the top, and is disposed at a center in the front-rear direction and in the left-right direction of the seal region 30.

One cathode-side opening 18 is formed, in the cathode-side substrate 8, at a position corresponding to a left side portion of the rear end portion of the cathode-side conductive layer 9.

One cathode-side conductive portion 17 is formed per one cathode-side opening 18.

As shown in FIG. 7, by providing one cathode-side conductive layer 9 per one cathode-side current collecting layer 14, the structure of the cathode-side conductive layer 9 can be made simple; the cathode-side conductive layer 9 having a large area compared with the cathode-side conductive layer 9 of FIG. 1 can be formed; and a large amount of electrical energy can be taken out.

On the other hand, as shown in FIG. 1, by providing a plurality of cathode-side conductive layers 9 per one cathode-side current collecting layer 14, compared with the cathode side conductive layer 9 of FIG. 7, a large number of current collecting portions can be secured, and efficient current collection can be achieved.

Although four cathode-side conductive layers 9 are provided per one cathode-side current collecting layer 14 in FIG. 1, the number of the cathode-side conductive layers 9 is not particularly limited as long as the number is plural, and for example, two or three, for example, five or more, or preferably 100 or more of the cathode-side conductive layers 9 can be provided.

Furthermore, although one cathode-side conductive portion 17 is provided per one cathode-side conductive layer 9 in the above description, for example, as shown in FIGs. 9 and 10, a plurality (five) of cathode-side conductive portions 17 can be provided per one cathode-side conductive layer 9.

In FIGs. 9 and 10, a plurality of cathode-side conductive portions 17 corresponding to one cathode-side conductive layer 9 are disposed with a space provided therebetween in the front-rear direction.

Furthermore, the cathode-side substrate 8 is formed with a plurality of cathode-side openings 18 below each of the cathode-side conductive layer 9 and in correspondence with the cathode-side conductive portions 17.

As shown in FIGs. 9 and 10, by providing the plurality of cathode-side conductive portions 17 per each (one) of the cathode-side conductive layer 9, compared with the cathode-side conductive portion 17 of FIG. 1, uniform current collecting is possible along the front-rear direction. Therefore, efficient current collection can be achieved.

Furthermore, although the cathode-side current collecting terminal 16 is provided on the lower face of the cathode-side substrate 8 in the above-description, for example, as shown in FIGs. 11 and 12, the cathode-side current collecting terminal 16 can also be provided on the upper face of the cathode-side substrate 8.

In FIGs. 11 and 12, the cathode-side current collecting terminal 16 is provided on the upper face (facing side or surface that faces the electrolyte 4) of the cathode-side substrate 8 in the take-out region 31.

Furthermore, in the take-out region 31, the cathode-side substrate 8 is formed with second openings 33 extending through in the thickness direction at a position corresponding to the rear end portion of the respective cathode-side current collecting wirings 15.

The second openings 33 are opened into a generally circular shape when viewed from the top; a plurality (four) of second openings 33 are formed in the width direction with a space provided therebetween; and the second openings 33 are filled with second conductive portions 34.

The second conductive portions 34 allows electrical conduction between the cathode-side current collecting terminal 16 and the rear end portion of the cathode-side current collecting wiring 15 in the thickness direction thereof. Examples of the material that forms the second conductive portions 34 include the above-described conductive materials for the cathode-side conductive portion (first conductive portion) 17.

The counter electrode 3 of FIGs. 11 and 12 are formed in the same manner as the description above, except that the second openings 33 are formed simultaneously with the cathode-side openings (first opening) 18, and the second conductive portions 34 are formed simultaneously with the cathode-side conductive portion (first conductive portion) 17, and the cathode-side current collecting terminal 16 is formed simultaneously with the cathode-side conductive layer 9.

As shown in FIGs. 11 and 12, by providing the cathode-side current collecting terminal 16 on the upper face of the cathode-side substrate 8, the cathode-side substrate 8 can achieve protection against external contacts, to be more specific, contacts from a lower side of the cathode-side substrate 8. Therefore, excellent connection reliability can be ensured.

On the other hand, as shown in FIGs. 2 and 4, by providing the cathode-side current collecting terminal 16 at the lower face of the cathode-side substrate 8, electricity can be easily taken out to the outside, to be more specific, at a lower side of the cathode-side substrate 8. Therefore, excellent handleability can be secured.

Furthermore, in the above-described counter electrode 3 shown in FIGs. 2 and 4, the cathode-side current collecting terminal 16 is provided on the lower face of the cathode-side substrate 8 in the take-out region 31, but for example, although not shown, the cathode-side current collecting terminal 16 can also be provided in the seal region 30.

By providing the cathode-side current collecting terminal 16 in the seal region 30, the take-out region 31 does not have to be defined in the cathode-side substrate 8. Therefore, the cathode-side substrate 8 can be made into a small size, and the counter electrode 3 can be made into a small size. Or, by not providing the take-out region 31, the seal region 30 having a large area can be ensured, and therefore the cathode-side current collecting layer 14 and the catalyst layer 10 having a large area can be ensured, and an improvement in power generation efficiency can be achieved.

Furthermore, although the entire surface of the cathode-side conductive layer 9 is covered with the catalyst layer 10 in the above-description, for example, as shown in FIGs. 13 to 15, by covering a portion of the surface of the cathode-side conductive layer 9 with the catalyst layer 10 and exposing the rest of the area, it is also possible to allow the rest of the area to serve as a current collecting region 36.

In the counter electrode 3 of FIGs. 13 to 15, each of the cathode-side conductive layers 9 is formed into a generally U-shape opening toward the rear side when viewed from the top. To be more specific, the cathode-side conductive layer 9 includes a conductive region 35, a current collecting region 36, and a connecting region 37 provided continuously. The conductive region 35 and the current collecting region 36 extend in the front-rear direction and are disposed with a space provided therebetween in the left-right direction; and the connecting region 37 connects the front end portions of the conductive region 35 and the current collecting region 36.

The conductive region 35 is disposed at the left side in respective cathode-side conductive layers 9, and the surface of the conductive region 35 is covered with the catalyst layer 10.

The current collecting region 36 is disposed at the right side of the conductive region 35 with a space provided therebetween. The rear end portion of the current collecting region 36 is continuous with the cathode-side conductive portion 17.

The surface of the current collecting region 36 and the connecting region 37 is exposed from the catalyst layer 10, but a second protection layer 21 is formed thereon.

Examples of the material that forms the second protection layer 21 include the above-described materials for the first protection layer 13. Furthermore, the thickness of the second protection layer 21 is the same as the thickness of the first protection layer 13.

The counter electrode 3 shown in FIGs. 14 and 15 is produced in the same manner as described above, except that the second protection layer 21 is simultaneously formed with the first protection layer 13.

In this counter electrode 3, electricity generated in the conductive region 35 can be efficiency taken out from the cathode-side current collecting layer 14 via the connecting region 37, the current collecting region 36, and the cathode-side conductive portion 17.

Furthermore, in the description above, the conductive portion is provided only in the counter electrode 3, and such a counter electrode 3 is given as an example of the dye-sensitized solar cell electrode of the present invention. However, for example, the conductive portion can be provided only in the working electrode 2, and the working electrode 2 can be given as an example of the dye-sensitized solar cell electrode of the present invention; and furthermore, as shown in FIGs. 14 and 15, the conductive portion can be provided in both of the working electrode 2 and the counter electrode 3, and both of the working electrode 2 and the counter electrode 3 can be given an example of the dye-sensitized solar cell electrode of the present invention.

In FIGs. 14 and 15, the working electrode 2 includes an anode-side substrate 5 as the substrate; an anode-side conductive layer 6 formed on the lower face (facing side or one side that faces the electrolyte 4) of the anode-side substrate 5 as the conductive layer; an anode-side current collecting layer 24 formed on the upper face (opposite side or the other side surface of the facing side that faces the electrolyte) of the anode-side substrate 5 as the current collecting layer; and an anode-side conductive portion 27 as the conductive portion. The working electrode 2 also includes a dye-sensitized semiconductor layer 7, an anode-side cover layer 29, a third protection layer 38, and a fourth protection layer 39.

The anode-side substrate 5, the anode-side conductive layer 6, the anode-side current collecting layer 24, the anode-side conductive portion 27, the dye-sensitized semiconductor layer 7, the anode-side cover layer 29, the third protection layer 38, and the fourth protection layer 39 of the working electrode 2 are formed so as to be generally symmetrical to the above-described cathode-side substrate 8, cathode-side conductive layer 9, cathode-side current collecting layer 14, cathode-side conductive portion 17, catalyst layer 10, cathode-side cover layer 20, first protection layer 13, and second protection layer 21 of the counter electrode 3, respectively, with the electrolyte 4 as the center in the thickness direction.

That is, the anode-side substrate 5 is sectioned into a seal region 30 and a take-out region 31. The anode-side substrate 5 is formed with an anode-side opening 28 as an opening which is filled with an anode-side conductive portion 27.

The anode-side conductive layer 6 includes a conductive region 35 (FIG. 15), a current collecting region 36, and a connecting region 37 (not shown in FIGs. 14 and 15); and the conductive region 35 (FIG. 15), the current collecting region 36, and the connecting region 37 are formed into a generally symmetrical form with the conductive region 35, the current collecting region 36, and the connecting region 37 of the cathode-side conductive layer 9, respectively, with the electrolyte 4 as the center in the thickness direction.

Furthermore, the anode-side current collecting layer 24 includes an anode-side current collecting wiring 25 and an anode-side current collecting terminal 26, and the anode-side current collecting wiring 25 and the anode-side current collecting terminal 26 are formed generally into a symmetrical form with the cathode-side current collecting wiring 15 and the cathode-side current collecting terminal 16 of the cathode-side current collecting layer 14 with the electrolyte 4 as the center in the thickness direction.

The anode-side cover layer 29 covers a surface of the anode-side current collecting wiring 25.

The third protection layer 38 covers a surface of the anode-side current collecting terminal 26.

The fourth protection layer 39 covers the reverse side of the current collecting region 36 of the anode-side conductive layer 6.

In this working electrode 2, the anode-side conductive portion 27 allows electrical connection between the anode-side conductive layer 6 and the anode-side current collecting layer 24 in the thickness direction of the anode-side substrate 5.

Therefore, in the dye-sensitized solar cell 1 in which this working electrode 2 is used, excellent sealing performance of the sealing layer 11 against the electrolyte 4 can be ensured, in particular, without penetration of the rear beam 11A by the anode-side conductive layer 6. At the same time, generated electricity can be efficiency taken out from the anode-side current collecting terminal 26 via the anode-side conductive portion 27 and the anode-side current collecting wiring 25.

Thus, with the dye-sensitized solar cell 1, a reduction in power generation efficiency and contamination of surroundings can be prevented.

Moreover, because the counter electrode 3 and the working electrode 2 are provided with the above-described cathode-side conductive portion 17 and the anode-side conductive portion 27, respectively, in the dye-sensitized solar cell 1 of FIGs. 14 and 15, a reduction in power generation efficiency and contamination of surroundings can be prevented even more.

## Claims

1. A dye-sensitized solar cell electrode comprising:
a substrate,
a conductive layer that is formed on one side surface of the substrate and is surrounded by a sealing layer for sealing in an electrolyte,
a current collecting layer formed on the other side surface of the substrate, and
a conductive portion that allows electrical conduction between the conductive layer and the current collecting layer in a thickness direction of the substrate.

2. The dye-sensitized solar cell electrode according to Claim 1, wherein the current collecting layer is disposed so as to traverse the sealing layer when projected in the thickness direction of the substrate.

3. The dye-sensitized solar cell electrode according to Claim 1, wherein the substrate is formed with an opening that extends through in the thickness direction, and
the conductive portion fills in the opening.

4. The dye-sensitized solar cell electrode according to Claim 1, wherein the conductive layer is provided in a plural number per one current collecting layer.

5. The dye-sensitized solar cell electrode according to Claim 1, wherein the conductive portion is provided in a plural number per one conductive layer.

6. The dye-sensitized solar cell electrode according to Claim 1, wherein the current collecting layer comprises:
a current collecting wiring formed continuously with the conductive portion, and
a current collecting terminal formed continuously with the current collecting wiring,
wherein the current collecting terminal is provided on one side surface of the substrate.

7. The dye-sensitized solar cell electrode according to Claim 1, wherein the current collecting layer comprises:
a current collecting wiring formed continuously with the conductive portion, and
a current collecting terminal formed continuously with the current collecting wiring,
wherein the current collecting terminal is provided on the other side surface of the substrate.

8. A dye-sensitized solar cell comprising:
a working electrode,
a counter electrode disposed to face the working electrode with a space provided therebetween,
a sealing layer disposed between the working electrode and the counter electrode, and
an electrolyte that fills in between the working electrode and the counter electrode, and is sealed in by the sealing layer,
wherein the working electrode and/or the counter electrode is a dye-sensitized solar cell electrode comprising:
a substrate,
a conductive layer that is formed on one side surface of the substrate and is surrounded by a sealing layer for sealing in an electrolyte,
a current collecting layer formed on the other side surface of the substrate, and
a conductive portion that allows electrical conduction between the conductive layer and the current collecting layer in a thickness direction of the substrate.
